# EUROPÄISCHE PATENTSCHRIFT

(11) **EP 1 972 996 B1**
(45) Veröffentlichungstag und Bekanntmachung des Hinweises auf die Patenterteilung: **13.10.2010**
(21) Anmeldenummer: 07005791.4
(22) Anmeldetag: 21.03.2007
(51) Int. Cl.: G03F 7/00

(54) **Verfahren und Vorrichtung zur Erzeugung einer nanostrukturierten Scheibe**
Method and device for generating a nanostructured disc
Procédé et dispositif destinés à la production d'une plaque nanostructurée

(43) Veröffentlichungstag der Anmeldung: 24.09.2008
(73) Patentinhaber: Thallner, Erich, Dipl.-Ing., 4782 St. Florian (AT)
(72) Erfinder: Thallner, Erich, Dipl.-Ing., 4782 St. Florian (AT)
(74) Vertreter: Schweiger, Johannes

(56) Entgegenhaltungen:
- EP-A- 1 669 196
- WO-A-03/065120
- WO-A-2006/006854
- WO-A-2007/067488
- SE-C2- 522 237
- US-A1- 2003 178 316
- US-A1- 2004 101 713
- US-A1- 2004 149 367
- US-A1- 2004 229 140
- US-A1- 2005 133 954
- US-B1- 6 757 116
- US-B1- 6 814 898
- US-B1- 6 869 557
- US-B1- 6 949 199
- US-B1- 7 074 341
- GLINSNER T ET AL: "NANOIMPRINT LITHOGRAPHY ENABLES PATTERNED TRACKS FOR HIGH-CAPACITY HARD DISKS" SOLID STATE TECHNOLOGY, PENNWELL CORPORATION, TULSA, OK, US, Bd. 48, Nr. 3, März 2005 (2005-03), Seiten 51-52,54, XP001227287 ISSN: 0038-111X
- WU WEI ET AL: "Large area high density quantized magnetic disks fabricated using nanoimprint lithography" JOURNAL OF VACUUM SCIENCE & TECHNOLOGY B: MICROELECTRONICS PROCESSING AND PHENOMENA, AMERICAN VACUUM SOCIETY, NEW YORK, NY, US, Bd. 16, Nr. 6, November 1998 (1998-11), Seiten 3825-3829, XP012007291 ISSN: 0734-211X
- ISLAM R ET AL: "One micron precision optically aligned method for hot-embossing and nanoirnprinting" PROCEEDINGS OF IEEE SENSORS 2002. ORLANDO, FL, JUNE 12 - 14, 2002, IEEE INTERNATIONAL CONFERENCE ON SENSORS, NEW YORK, NY : IEEE, US, Bd. VOL. 1 OF 2. CONF. 1, 12. Juni 2002 (2002-06-12), Seiten 931-935, XP010605233 ISBN: 0-7803-7454-1

## Beschreibung

Die Erfindung betrifft ein Verfahren und eine Vorrichtung gemäß den Oberbegriffen der Ansprüche 1 und 10 sowie die Verwendung eines nanostrukturierten Stempels, eine Scheibe mit einer definierten Nanostruktur und ein Festplattenlaufwerk mit einer solchen Scheibe.

Bekannte Festplattenlaufwerke bestehen aus einer oder mehreren Schreiben, die mit magnetisierbarem Material in ringförmiger Struktur auf einer oder beiden Flachseiten der Scheibe ausgestattet sind. Zum Auslesen der magnetisierten Struktur weisen Festplattenlaufwerke mindestens eine Lese-/Schreibeinheit auf. Derzeit werden ausschließlich unstrukturierte Scheiben eingesetzt.

Bekannte Verfahren und Vorrichtungen zur Bearbeitung von strukturierten Substraten sind in der SE 522 237 C2, der US 6 757 116 B1, der WO 2006/006854 A, der WO 03/065120 A, der US 2005/133954 A1, der US 2003/178316 A1, dem Glinsner T et al: Nanoimprint lithograpfy enables patterned tracks for high-capacity hard disks" Solid State Technologie, Pennwell Corporation, Tulsa, Ok, US, Bd. 48, Nr. 3, März 2005, der US 2004/101713 A1, der US 6 869 557 B1, der US 6 949 199 B1 und der US 6 814 898 B1 beschrieben.

Auf Grund der steigenden Anforderung an immer höhere Speicherdichten ist es wünschenswert, die Abmessungen der auf den Scheiben aufgebrachten magnetisierbaren Schicht zu verkleinern.

Magnetisierbare Strukturen für strukturierte Scheiben (sogenannte "patterned media") können theoretisch auch durch Prägeverfahren erzeugt werden, indem beispielsweise eine Scheibe durch einen Roboterarm meist durch zentrisches Greifen im Mittenloch der Scheibe auf einem Prägestempel abgelegt wird und der oberhalb befindliche Prägestempel nach Justierung auf die darunter liegende Scheibe geführt wird, wobei unter Ausübung von erheblichem mechanischen Druck von 10 N/cm² bis zu 100 kN/cm² auf das zu prägende Polymermaterial der Scheibe geprägt wird.

Bei der Verwendung von Quarzstempeln sind ebenfalls erhebliche Prägekräfte sowie zusätzlich eine erhebliche Aushärtezeit des Materials erforderlich, wodurch der Durchsatz bei der Erzeugung der Scheiben erheblich eingeschränkt wird und dadurch die Produktionskosten sowie die Produktionsgeschwindigkeit erheblich steigen.

Weitere Nachteile der beschriebenen Verfahren sind die Justiergenauigkeit der Prägestempel wegen der hohen, auf die Scheibe aufzubringenden Kräfte sowie Probleme mit der Verschmutzung der Stempel.

Von erheblicher Bedeutung für solche Speicherscheiben ist es auch, die konzentrischen Strukturen mit sehr hoher Genauigkeit exakt zur Rotationsachse der Speicherscheiben auszurichten. Eine außerzentrische Übertragung würde das Nachführen des Lesekopfes eines Festplattenlaufwerks unmöglich machen, da mittlerweile Umdrehungszahlen von über 7.000 Umdrehungen pro Minute üblich sind.

Bei beidseitig strukturierten Speicherscheiben ist es erforderlich, dass die Strukturen der zweiten Seite möglichst exakt den Strukturen der ersten Seite entsprechen.

Der Erfindung liegt daher die Aufgabe zugrunde, eine schneller arbeitende Vorrichtung sowie ein entsprechendes Verfahren vorzuschlagen, bei welchem möglichst kleine Strukturen auf Scheiben aufgebracht werden können.

Darüber hinaus besteht die Aufgabe, möglichst kostengünstig erzeugte Scheiben für Festplattenlaufwerke vorzusehen, die kleinere Strukturen aufweisen und dabei schnell und kostengünstig erzeugt werden können.

Diese Aufgabe wird vorrichtungsgemäß mit den Merkmalen des Anspruchs 1 und verfahrensgemäß mit den Merkmalen des Anspruchs 10 sowie bezüglich der vorzuschlagenden Scheibe mit den Merkmalen des Anspruchs 14 gelöst.

Grundidee der vorliegenden Erfindung ist die Anwendung des Mikrokontaktdrucks (microcontact printing-µCP) bei der Erzeugung solcher mikro- und/oder nanostrukturierter Erzeugnisse/Substrate. Dabei ist im Unterschied zu den im Stand der Technik bekannten Verfahren ein Lithographieschritt erforderlich.

Vorteil des Aufdruckens ist, dass die Strukturen sehr schnell übertragen werden können und kaum bzw. äußerst geringe Druckkräfte auf die Scheiben ausgeübt werden müssen. Die Druckkraft liegt zwischen 0,05 und 5 N/cm², bevorzugt zwischen 0,05 und 2 N/cm². Es reicht teils die durch das Stempelgewicht eingebrachte Kraft. Der erzielbare Durchsatz bei der Erzeugung der Scheiben ist ebenfalls deutlich besser.

Auf Grund der geringeren Druckkräfte, die durch die Vorrichtung übertragen werden müssen, ist es möglich, die erforderlichen Positioniergenauigkeiten der Stempel zueinander und der Stempel zu den zu stempelnden Scheiben auch bei deutlich kleineren und engeren Strukturen einzuhalten.

Eine besondere Genauigkeit kann dadurch erreicht werden, dass der Stempel aus einem starren Träger gebildet ist und die Stempelstruktur sich möglichst unmittelbar an den starren Träger anschließt, um eine Wechselwirkung zwischen benachbarten erhabenen Strukturen des Stempels möglichst zu vermeiden. Dabei sollte auf eine möglichst innige Verbindung zwischen der Stempelstruktur und dem Träger des Stempels geachtet werden. Hierdurch werden horizontal wirkende Kräfte beim Stempeln und daraus resultierende Verschiebungen der Stempelstruktur weitestgehend vermieden, so dass eine sehr präzise Abbildung der Stempelstruktur möglich ist. Die Justiergenauigkeit ist dabei unterhalb von 20µm.

Eine besonders innige Verbindung kann durch poröses Trägermaterial, insbesondere Keramik erreicht werden, wobei der Träger von dem Stempelmaterial durchzogen ist und lediglich die Stempelstruktur den Träger überragt.

In ihrer allgemeinsten Ausführungsform weist die Vorrichtung mindestens einen nanostrukturierten Stempel, vorzugsweise einen Poly-Dimethyl-Siloxan(PDMS)-Stempel, zur Übertragung einer definierten Nanostruktur des nanostrukturierten Stempels auf die Scheibenoberseite und/oder die Scheibenunterseite gemäß Anspruch 1 auf.

In seiner allgemeinsten Ausführungsform umfasst das Verfahren die Verfahrensschritte gemäß Anspruch 9 auf.

Indem die Vorrichtung zwei gegenüberliegend ausgerichtete nanostrukturierte Stempel aufweist und die Scheibe zwischen den Stempeln ausgerichtet anordenbar ist, ist es mit Vorteil möglich, die Scheibe zur gleichen Zeit beidseitig mit einer Struktur zu versehen. Diese Maßnahme bringt es außerdem mit sich, dass für die Strukturierung beider Scheibenseiten nur eine Druckkraft aufgebracht werden muss. Dies führt zum einen zu einer Energieeinsparung und zum anderen zu einer Verdoppelung der Arbeitsgeschwindigkeit bei der Herstellung oder zu einer Verdoppelung der Speicherkapazität der Scheibe.

In einer vorteilhaften Ausgestaltung ist vorgesehen, dass die Vorrichtung mindestens eine jedem Stempel zugeordnete Stempelaufnahmeeinheit aufweist. Dadurch ist der Stempel je nach Anwendung abnehmbar oder austauschbar. Der Stempelaufnahmeeinheit ist jeweils eine Positioniereinheit zugeordnet, mit welcher die Stempelaufnahmeeinheit zusammen mit dem an der Stempelaufnahmeeinheit angebrachten Stempel in eine beliebige Position parallel zu der Scheibe verfahren werden kann. Besonders vorteilhaft ist es, die Positioniereinheiten in je eine Einheit zur Verfahrung in X-, Y-, und Z-Richtung aufzuteilen, wobei die X- und Y-Richtung eine Ebene parallel zu der Scheibe 7 bilden und die Z-Richtung sich orthogonal zu der Scheibe erstreckt. Durch diese Maßnahme wird die erforderliche Genauigkeit der Positionierung/Justierung/Ausrichtung des jeweiligen Stempels zu der Scheibe erhöht, bis zu maximal +/-5µm Abweichung und weniger.

Bei mehreren Stempeln sind zusätzlich Positioniereinheiten vorgesehen, die die Stempel zueinander ausrichten, um die auf der Scheibe gegenüberliegend angeordneten Strukturen möglichst genau fluchtend zueinander auszurichten, wobei eine Überdeckung der einzelnen, korrespondierenden Strukturen, wie beispielsweise Vertiefungen, in der Flucht von mindestens 30 % bevorzugt aber mehr als 70 % einstellbar ist. Die gegenüberliegenden Strukturen weichen beim vorliegenden Verfahren um weniger als 20µm, bevorzugt weniger als 5µm voneinander ab.

Mit Vorteil sind die Stempel über Stempelhalter an der Stempelaufnahmeeinheit fixierbar, wobei die Fixierung insbesondere durch Anlegen eines Unterdrucks an zwischen der Stempelaufnahmeeinheit und dem Stempelhalter angeordneten Vakuumrillen erfolgt. Die Positionierung kann in besonders vorteilhafter Weise erfolgen, indem die Positioniereinheiten eine separate Scheibenpositioniereinheit in X-Richtung, Y-Richtung und Z-Richtung für die genaue Positionierung der Scheibe relativ zu dem der Scheibenunterseite zugeordneten Stempel und eine separate Stempelpositioniereinheit in X-Richtung, Y-Richtung und Z-Richtung für die genaue Positionierung des der Scheibenoberseite zugeordneten Stempels zu dem mit der Scheibe ausgerichteten Stempel umfassen.

Dadurch, dass die Positionierung/Ausrichtung der Scheibe und der Stempel zueinander über eine Zentrale, durch Steuerleitungen mit den Positioniereinheiten und, vorzugsweise optischen, Erfassungsmitteln verbundene zentrale Steuereinheit gesteuert ist, werden alle für das Verfahren erforderlichen Parameter und Vorgaben an einer Stelle zusammengefasst ausgewertet und, falls erforderlich, kann entsprechend zentral gesteuert reagiert werden.

Die Position der Scheibe ist möglichst genau zu erfassen, wobei mindestens drei, vorzugsweise vier, radial zu einer vorgegebenen Scheibenaufnahmeposition definiert beabstandete Erfassungseinheiten zur Erfassung der genauen Position der Scheibe in X-Richtung und Y-Richtung als Scheibenpositionsinformation vorgesehen sind. Die Scheibenaufnahmeposition ist die Position, in der die Scheibe auf der Aufnahmeeinrichtung abgelegt wurde, beispielsweise durch einen Roboterarm. Die Scheibenpositionsinformation ist über eine Leitung von der zentralen Steuereinheit abrufbar, um eine möglichst genaue Ausrichtung der Scheibe zu den beiden Stempeln oder umgekehrt der Stempel zu der Scheibe zu ermöglichen.

Indem die Scheibe genau zentrisch auf eine Aufnahmeeinheit aufnehmbar ist und die Aufnahmeeinheit zwischen der Scheibe und den Scheibenpositioniereinheiten angeordnet ist, werden die konzentrischen Strukturen mit sehr hoher Genauigkeit zentrisch zum Mittenloch bzw. zur späteren Rotationsachse der Scheibe übertragen.

Eine genaue Positionierung des oberen Stempels zu dem vorher mit der Scheibe ausgerichteten unteren Stempel ist möglich, indem die Aufnahmeeinheit eine genau dem Zentrum der Scheibe zuordnenbare Markierung aufweist, und eine an der Stempelaufnahmeeinheit des oberen Stempels angebrachte Erfassungseinheit den Versatz und/oder den Abstand des oberen Stempels zu der Scheibe als Stempelpositionsinformation erfasst, wobei die Stempelpositionsinformation über eine Leitung von der Steuereinheit abrufbar ist.

Auf Grund dieser Stempelpositionsinformation und der bekannten Lage der Scheibe sowie des unteren Stempels (Scheibenpositionsinformation) kann eine hochgenaue Positionierung bzw. Ausrichtung des oberen Stempels über der Scheibe sowie relativ zur Scheibe und dem Stempel, gesteuert durch die zentrale Steuereinheit, erfolgen, so dass einerseits die Stempelstrukturen auf der oberen und unteren Seite der Scheibe möglichst genau fluchtend zueinander angeordnet/ausgerichtet sind und zum anderen die Ausrichtung der konzentrischen Strukturen genau zur späteren Rotationsachse der Scheibe erfolgt.

Bei dem erfindungsgemäßen Verfahren wird die Scheibe zunächst über einen Roboter bzw. Roboterarm auf die Aufnahmeeinheit abgelegt, wobei die Scheibe nach Ablage auf der Aufnahmeeinheit vorzugsweise einen sehr geringen Abstand von einigen µ-Metern zu dem Stempel aufweist. Die Scheibe wird bevorzugt bereits parallel zu dem Stempel ausgerichtet auf der Aufnahmeeinheit aufgenommen. Nach Ablage der Scheibe wird über seitliche Erfassungsmittel die Position der Scheibe zu dem unteren Stempel erfasst, von der zentralen Steuereinheit abgerufen, erforderlichenfalls konvertiert und anschließend wird die Scheibe durch die Aufnahmeeinheit bewegende Positioniereinheiten genau zentrisch über dem Stempel ausgerichtet. Zeitgleich oder unmittelbar im Anschluss an die Ausrichtung der Scheibe zu dem unteren Stempel wird der obere Stempel über obere Positioniereinheiten zu dem unteren Stempel ausgerichtet, so dass die korrespondierenden Strukturen genau fluchtend zueinander ausgerichtet sind. Die übereinstimmende Ausrichtung des oberen und unteren Stempels kann durch einen Probeprint vorab ermittelt und als Parameter in die zentrale Steuereinheit eingegeben werden (Kalibrierung).

Nach Einstellung der X- und Y-Ausrichtung der Stempel und Scheibe, wird die Aufnahmeeinheit der Scheibe über eine in Z-Richtung wirkende Positionseinheit nach unten abgesenkt, bis die Scheibe auf dem darunter liegenden unteren Stempel aufliegt und die Scheibenunterseite mit dem Stempel in Kontakt ist. Während des Absenkens kann erforderlichenfalls eine Nachjustierung in X- und Y-Richtung erfolgen, um eventuelle Veränderungen der vorher angefahrenen Lage der Scheibe während des Absenkvorganges auf den Stempel auszugleichen.

Zeitgleich oder unmittelbar im Anschluss daran wird der obere Stempel über die dem oberen Stempel zugeordnete, in Z-Richtung wirkende Positioneinheit nach unten in Richtung auf die Scheibe abgesenkt, wobei durch ständiges Messen der Solllage des oberen Stempels zu dem unteren Stempel über Erfassungsmittel und entsprechende Lagekorrektur in X-und Y-Richtung über Positionseinheiten, gesteuert durch den zentralen Rechner, die genaue Ausrichtung des oberen Stempels gewährleistet wird.

Zusätzlich erforderliche Parameter, wie beispielsweise die Dicke der Scheibe können manuell in die zentrale Steuereinheit eingegeben oder durch weitere Erfassungsmittel automatisch erfasst werden.

Vorteilhafte Weiterbildungen der Erfindung sind in den Unteransprüchen angegeben.

Weitere Vorteile und zweckmäßige Ausführungen der Erfindung sind in den weiteren Ansprüchen, den Figuren, der Beschreibung und den Zeichnungen wiedergegeben.
- Fig. 1: zeigt eine geschnittene, schematische Seitenansicht einer erfindungsgemäßen Vorrichtung,
- Fig. 2: eine geschnittene, schematische Aufsicht auf die erfindungsgemäße Vorrichtung und
- Fig. 3: einen erfindungsgemäßen Stempel mit Stempelhalter in Aufsicht und geschnittener Seitenansicht.

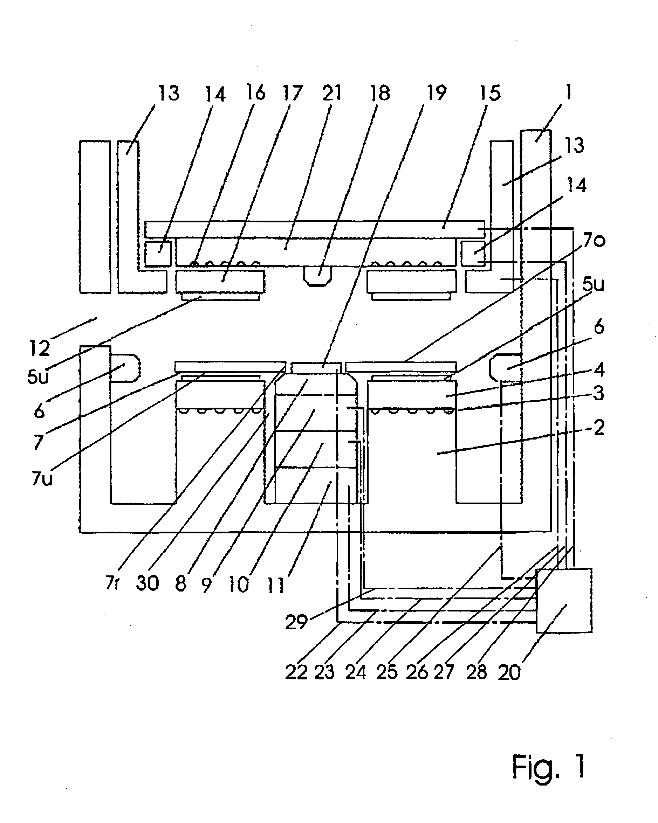

Bei der in Fig. 1 dargestellten, erfindungsgemäßen Hochpräzisionsvorrichtung ist mit Bezugszeichen 1 ein Gehäuse bezeichnet, das die Vorrichtung im Wesentlichen vollständig umschließt. Ein Gehäuse ist nicht erforderlich. Vielmehr reicht eine formstabile Verbindung zwischen oberer und unterer Stempeleinheit, beispielsweise durch Säulen oder einseitige Träger(-arme). Eine zentrale Steuereinheit 20, die auch einen Datenspeicher, einen Bildschirm, eine Eingabetastatur und eine Recheneinheit umfasst, kann auch außerhalb des Gehäuses 1 angeordnet sein und über Leitungen 22, 23, 24, 25, 26, 27, 28 und 29 mit entsprechenden Bauteilen der Vorrichtung verbunden sein.

Am Gehäuseboden ist, vorzugsweise einstückig mit dem Gehäuse 1, eine Stempelaufnahmeeinheit 2 als ringförmige Ausformung angeformt oder angebracht. Über eine nicht dargestellte Vakuumleitung, die mit einer Vakuumanlage verbunden ist, kann auf der oberen Flachseite der Stempelaufnahmeeinheit 2 an Vakuumrillen 3 ein Unterdruck angelegt werden, vermittels dessen ein plan anliegender Stempelhalter 4 auf der Stempelaufnahmeeinheit 2 gehalten wird.

Auf dem Stempelhalter 4 ist ein unterer PDMS-Stempel 5u aufgebracht und sowohl die Oberfläche der Stempelaufnahmeeinheit 2 als auch der Stempelhalter 4 und der untere PDMS-Stempel 5u sind plan eben sowie plan parallel angeordnet.

In dem von der ringförmigen Stempelaufnahmeeinheit 2 und dem Boden des Gehäuses 2 begrenzten, nach oben offenen Freiraum 30 sind Scheibenpositioniereinheiten 9, 10 und 11 angeordnet, die jeweils für die Positionierung der auf den Scheibenpositioniereinrichtungen 9, 10 und 11 angeordneten Aufnahmeeinheit 8 zur Aufnahme der Scheibe 7 sorgen. Die unterste Scheibenpositioniereinheit 11 kann, gesteuert über die zentrale Steuereinheit 20, eine Verschiebung der Aufnahmeeinheit 8 in Y-Richtung, d.h. in Zeichnungsebene hinein und aus dieser heraus, bewirken. Die darüber angeordnete Scheibenpositioniereinheit 10 sorgt für eine Verschiebung in X-Richtung, d.h. in Zeichnungsebene nach links und nach rechts. Die über der Scheibenpositioniereinheit 10 angeordnete Scheibenpositioniereinheit 9 sorgt für eine Verschiebung in Z-Richtung, d.h. in Zeichnungsebene nach oben und unten. Die Scheibenpositioniereinheiten 9, 10 und 11 können auch in beliebiger anderer Reihenfolge übereinander angeordnet sein oder in einer einzigen Einheit zusammengefasst sein.

Die Aufnahmeeinheit 8 nimmt die Scheibe 7 im Bereich des Mittellochrandes 7r der Scheibe 7 auf, wobei die Aufnahme derart erfolgt, dass die Scheibe 7 parallel zu der Oberfläche des unteren PDMS-Stempels 5u angeordnet ist.

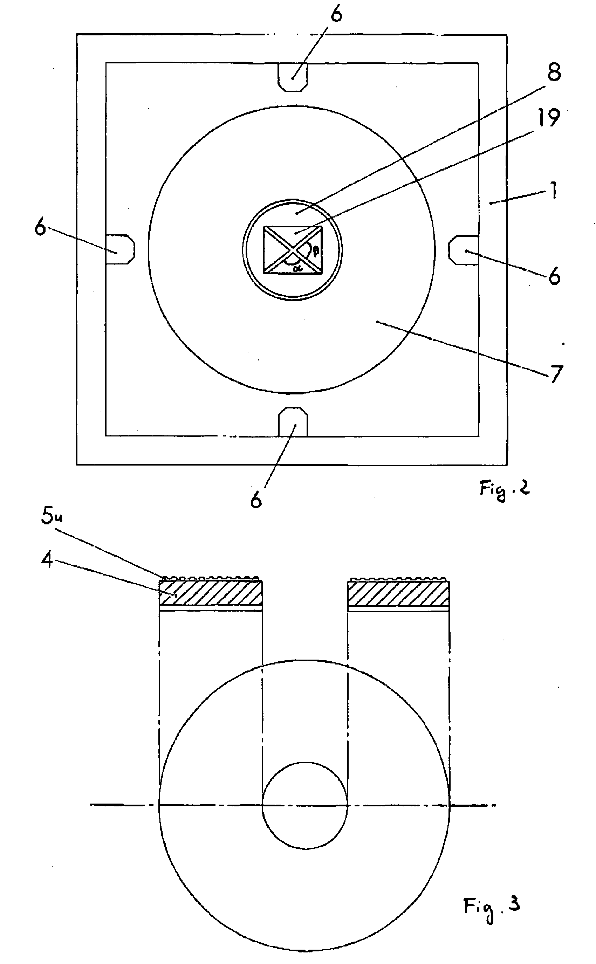

In der Ausgangsposition vor Ausrichtung der Scheibe 7 zu dem unteren PDMS-Stempel 5u ist die Scheibe 7 mit ihrer Scheibenunterseite 7u weniger µ-Meter über der Oberfläche des unteren PDMS-Stempels 5u angeordnet. In der durch die Scheibe 7 gebildeten Ebene befinden sich seitlich beabstandet von der Scheibe 7 über den Umfang verteilt vier Erfassungseinheiten 6 (siehe auch Fig. 2). Die Erfassungseinheiten 6 messen den Abstand zum Scheibenumfang der Scheibe 7, wobei aus dem Abstand eine Scheibenpositionsinformation berechenbar ist und die Scheibenpositionsinformation über eine Leitung 25 beziehungsweise über mehrere Leitungen 25 zu den vier Erfassungseinheiten 6 durch die zentrale Steuereinheit 20 abrufbar sind. Die Berechnung der Scheibenpositionsinformation erfolgt vorzugsweise in der zentralen Steuereinheit 20. Die Position des PDMS-Stempels 5u ist vorgegeben oder wird ebenfalls über Erfassungsmittel erfasst.

Die Scheibe 7 wird über eine seitliche Gehäuseöffnung 12 mittels eines Roboterarmes (nicht dargestellt) auf der Aufnahmeeinheit 8 abgelegt. Die Gehäuseöffnung 12 kann verschließbar ausgebildet sein.

Oberhalb der Scheibe 7 ist ein spiegelverkehrt zu dem unteren PDMS-Stempel 5u angeordneter oberer PDMS-Stempel 5o an einem Stempelhalter 17 angebracht, wobei die Einheit aus oberem PDMS-Stempel 5o und Stempelhalter 17 im Wesentlichen der in Fig. 3 dargestellten Baugruppe aus Stempelhalter 4 und unterem PDMS-Stempel 5u entspricht.

Der obere PDMS-Stempel 5o ist analog dem unteren PDMS-Stempel 5u an einer Stempelaufnahmeeinheit 21 über Vakuumrillen 16 fixiert. Die Stempelaufnahmeeinheit 21 ist über separate Stempelpositioniereinheiten 13, 14 und 15 in X-Richtung durch die Stempelpositioniereinheit 14, in Y-Richtung durch die Stempelpositioniereinheit 15 und in Z-Richtung durch die, vorzugsweise an der Innenwand des Gehäuses 1 geführte Stempelpositioniereinheit 13 praktisch beliebig parallel zu der Scheibe 7 verschiebbar.

Über eine optische Erfassungseinheit 18, die an der Stempelaufnahmeeinheit 21 mittig angebracht ist und die über nicht dargestellte Leitungen mit der zentralen Steuereinheit 20 verbunden sind, wird die Stempelpositionsinformation des oberen PDMS-Stempels 5o relativ zu dem unteren PDMS-Stempel 5u erfasst und an die zentrale Steuereinheit 20 übertragen bzw. von dieser abgerufen.

Die Positionserfassung in X- und Y-Richtung erfolgt durch eine auf der gegenüberliegend angeordneten Aufnahmeeinheit 8 aufgebrachte Markierung 19. Die Markierung 19 ist optisch so ausgestaltet, dass Rückschlüsse auf die seitliche Verschiebung in X- und Y-Richtung möglich sind, insbesondere durch zwei sich kreuzende Linien oder Vertiefungen, wobei die Kreuzungswinkel der beiden Linien/Vertiefungen α und β ungleich sind (siehe Fig. 2).

Umgekehrt kann auch statt der Markierung 19 ein Positionssensor vorgesehen sein, beispielsweise ein position sensitive device (PSD) oder ein 4-Quadrantensensor. Anstelle der optischen Erfassungseinheit 18 wäre dann ein Laser angebracht, den der Positionssensor erfasst.

Gemäß Fig. 1 ist die zentrale Steuereinheit über Leitung 22 mit der Markierung 19, über Leitungen 23, 24 und 29 mit den Scheibenpositioniereinheiten 11, 10 und 9 sowie über Leitungen 26, 27 und 28 mit den Stempelpositioniereinheiten 13, 14 und 15 verbunden.

Die fertig mikro- und/oder nanostrukturierte Scheibe 7 kann als Speicherscheibe für Festplattenlaufwerke verwendet werden, da sich die gegenüberliegenden Einzelstrukturen/Vertiefungen/Erhebungen genau fluchtend gegenüberliegen. Dies führt dazu, dass der Lesekopf eines Festplattenlaufwerkes kaum oder idealer Weise gar nicht nachgeführt werden muss und die Umdrehungszahl des Festplattenlaufwerkes entsprechend höher sein kann bzw. die Auslesegeschwindigkeit und Zugriffszeiten des Festplattenlaufwerkes verbessert werden. Die einzelnen Strukturen/Vertiefungen/Erhebungen der Scheibe 7 erreichen erfindungsgemäß eine Überdeckung der sich gegenüberliegenden, in Flucht befindlichen Strukturen von wenigstens 30 %, vorzugsweise jedoch mehr als 70 %, wobei die Abweichung der Strukturen kleiner als 20µm, vorzugsweise kleiner als 5µm beträgt.

Die Positionierung/Justierung kann alternativ oder zusätzlich zur optischen Positionierung/Justierung auch mechanisch bezüglich des Außendurchmessers der Scheibe 7 durchgeführt werden, da hierbei etwa die gleiche Positioniergenauigkeit erreicht wird und die Positionierung schneller abläuft.

Die Erfassungseinheit 6 kann alternativ als mechanischer Aktuator mit integrierten Positionsmesssystem ausgeführt sein. Die mindestens 3 Aktuatoren können dabei symmetrisch (wie ein Spannfutter) zusammenfahren und die Scheibe 7 an deren Umfang mechanisch zentrieren.

### Verfahren und Vorrichtung zur Erzeugung einer nanostrukturierten Scheibe

### Bezugszeichenliste

- 1: Gehäuse
- 2: ringförmige Stempelaufnahmeeinheit
- 3: Vakuumrillen
- 4: Stempelhalter
- 5u: unterer Stempel
- 5o: oberer Stempel
- 6: Erfassungseinheit
- 7: Scheibe
- 7u: Scheibenunterseite
- 7o: Scheibenoberseite
- 7r: Mittenlochrand
- 8: Aufnahmeeinheit
- 9: Positioniereinheit Z-Richtung
- 10: Positioniereinheit X-Richtung
- 11: Positioniereinheit Y-Richtung
- 12: Gehäuseöffnung
- 13: Positioniereinheit Z-Richtung
- 14: Positioniereinheit X-Richtung
- 15: Positioniereinheit Y-Richtung
- 16: Vakuumrillen
- 17: Stempelhalter
- 18: Erfassungseinheit
- 19: Markierung
- 20: zentrale Steuereinheit
- 21: Stempelaufnahmeeinheit
- 22: Leitung
- 23: Leitung
- 24: Leitung
- 25: Leitung
- 26: Leitung
- 27: Leitung
- 28: Leitung
- 29: Leitung
- 30: Freiraum

## Patentansprüche

1. Vorrichtung zur Erzeugung einer nanostrukturierten Scheibe (7) mit einer Scheibenoberseite (7o) und einer Scheibenunterseite (7u), wobei die Vorrichtung einen nanostrukturierten oberen Stempel (5o) und einen nanostrukturierten unteren Stempel (5u) zur Übertragung einer definierten Nanostruktur des unteren Stempels (5u) auf die Scheibenunterseite (7u) und zur Übertragung einer definierten Nanostruktur des oberen Stempels (5o) auf die Scheibenoberseite (7o) aufweist, **dadurch gekennzeichnet, dass** eine separate Scheibenpositioniereinheit (9, 10, 11) in x-Richtung (10), y-Richtung (11) und z-Richtung (9) für die genaue Positionierung der Scheibe (7) relativ zu dem der Scheibenunterseite (7u) zugeordneten Stempel (5u) und eine separate Stempelpositioniereinheit (13, 14, 15) in x-Richtung (14), y-Richtung (15) und z-Richtung (13) für die genaue Positionierung des der Scheibenoberseite (7o) zugeordneten Stempels (5o) zu dem mit der Scheibe (7) ausgerichteten Stempel (5u) vorgesehen ist.

2. Vorrichtung nach Anspruch 1,
**dadurch gekennzeichet**,
dass die Vorrichtung zwei gegenüberliegend, vorzugsweise parallel zueinander, ausgerichtete nanostrukturierte Stempel (5u, 5o) aufweist, wobei die Scheibe (7) zwischen den Stempeln (5u, 5o), vorzugsweise parallel zu den Stempeln (5u, 5o), ausgerichtet anordenbar ist.

3. Vorrichtung nach Anspruch 1 oder 2,
**dadurch gekennzeichnet,**
**dass** die Vorrichtung mindestens eine jedem Stempel (5u, 5o) zugeordnete Stempelaufnahmeeinheit (2, 21) aufweist, welcher/welchen die korrespondierende Scheibenpositioniereinheit (9, 10, 11, 13, 14, 15) zur genauen Positionierung der Scheibe (7) relativ zu dem/den Stempel(n) (5u, 5o) zugeordnet ist/sind.

4. Vorrichtung nach Anspruch 2,
**dadurch gekennzeichnet,**
**dass** die Stempel (5u, 5o) über Stempelhalter (4, 17) an der Stempelaufnahmeeinheit (2, 21) fixierbar sind, insbesondere durch Anlegen eines Unterdrucks an zwischen der Stempelaufnahmeeinheit (2, 21) und dem Stempelhalter (4, 17) angeordneten Vakuumrillen (3, 16).

5. Vorrichtung nach Anspruch 1,
**dadurch gekennzeichnet,**
**dass** die Positionierung/Ausrichtung der Scheibe (7) und der Stempel (5u, 5o) zueinander über eine zentrale, durch Steuerleitungen mit den Positioniereinheiten (9, 10, 11, 13, 14, 15) und, vorzugsweise optischen, Erfassungsmitteln (6, 18) verbundene zentrale Steuereinheit (20) gesteuert ist.

6. Vorrichtung nach Anspruch 5,
**dadurch gekennzeichnet,**
**dass** mindestens 3, vorzugsweise 4, radial zu einer vorgegebenen Scheibenaufnahmeposition definiert beabstandete Erfassungseinheiten (6) zur Erfassung der genauen Position der Scheibe (7) in x-Richtung und γ-Richtung als Scheibenpositionsinformation vorgesehen sind, wobei die Scheibenpositionsinformation über eine Leitung von der Steuereinheit (20) abrufbar ist.

7. Vorrichtung nach einem der vorhergehenden Ansprüche,
**dadurch gekennzeichnet,**
**dass** die Scheibe (7) genau zentrisch auf einer Aufnahmeeinheit (8) aufnehmbar ist und die Aufnahmeeinheit (8) zwischen der Scheibe (7) und den Scheibenpositioniereinheiten (9, 10, 11) angeordnet ist.

8. Vorrichtung nach Anspruch 7,
**dadurch gekennzeichnet,**
**dass** die Aufnahmeeinheit (8) eine genau dem Zentrum der Scheibe (7) zuordenbare Markierung (19) aufweist, und eine an der Stempelaufnahmeeinheit (21) des oberen Stempels (5o) angebrachte Erfassungseinheit (18) den Versatz und/oder den Abstand des oberen Stempels (5o) zu der Scheibe (7) als Stempelpositionsinformation erfasst, wobei die Stempelpositionsinformation über eine Leitung von der Steuereinheit (20) abrufbar ist.

9. Verfahren zur Erzeugung einer nanostrukturierten Scheibe (7) mit folgenden Verfahrensschritten:
a) Ablegen einer Scheibe (7) auf einer Aufnahmeeinheit (8) einer Vorrichtung zur Erzeugung einer nanostrukurierten Scheibe (7),
b) genaues Ausrichten der Scheibe (7) zu einem unteren Stempel (5u) mittels einer separaten Scheibenpositioniereinheit (9, 10, 11) in x-Richtung, y-Richtung und z-Richtung und zu einem oberen Stempel (5o) mittels einer separaten Scheibenpositioniereinheit (13, 14, 15) in x-Richtung, y-Richtung und z-Richtung und
c) Übertragen einer definierten Nanostruktur der nanostrukturierten Stempel (5u, 5o) auf die Scheibenunterseite (7u) und die Scheibenoberseite (7o) der Scheibe (7).

10. Verfahren nach Anspruch 9,
**dadurch gekennzeichnet,**
**dass** die Scheibe (7) zwischen den zwei gegenüberliegend, vorzugsweise parallel zueinander, ausgerichteten nanostrukturierten Stempeln (5u, 5o), vorzugsweise parallel zu den Stempeln (5u, 5o), ausgerichtet wird.

11. Verfahren nach Anspruch 9 oder 10,
**dadurch gekennzeichnet,**
**dass** die Ausrichtung der Scheibe (7) zu den Stempeln (5u, 5o) mittels die Relativpositionen der Scheibe (7) und der beiden Stempel (5u, 5o) erfassenden Erfassungsmitteln (6, 18) durch eine Positioniereinheiten (9, 10, 11, 13, 14, 15) steuernde zentrale Steuereinheit (20) gesteuert wird.

## Claims

1. Device for producing a nanostructured wafer (7) with a wafer top (7o) and a wafer bottom (7u), the device having a nanostructured upper die (5o) and a nanostructured lower die (5u) for transfer of a defined nanostructure of the lower die (5u) to the wafer bottom (7u) and for transfer of a defined nanostructure of the upper die (5o) to the wafer top (7o), **characterized in that** there is a separate wafer positioning unit (9, 10, 11) in the x-direction (10), y-direction (11) and z-direction (9) for exact positioning of the wafer (7) relative to the die (5u) assigned to the wafer bottom (7u) and a separate wafer positioning unit (13, 14, 15) in the x-direction (14), y-direction (15) and z-direction (13) for exact positioning of the die (5o) assigned to the wafer top (7o) to the die (5u) aligned with the wafer (7).

2. Device as claimed in Claim 1, wherein the device has two nanostructured dies (5u, 5o) aligned oppositely, preferably parallel to one another, and the wafer (7) can be arranged aligned between the dies (5u, 5o), preferably parallel to the dies (5u, 5o).

3. Device as claimed in Claim 1 or 2, wherein the device has at least one die receiving unit (2, 21) which is assigned to each die (5u, 5o) and to which the corresponding wafer positioning unit (9, 10, 11, 13, 14, 15) is assigned for exact positioning of the wafer (7) relative to the die/dies (5u, 5o).

4. Device as claimed in Claim 2, wherein the dies (5u, 5o) can be fixed by way of die holders (4, 17) on the die receiving unit (2, 21), especially by applying a negative pressure to the vacuum grooves (3, 16) which are located between the die receiving unit (2, 21) and the die holder (4, 17).

5. Device as claimed in Claim 1, wherein the positioning/alignment of the wafer (7) and the dies (5u, 5o) to one another is controlled by way of a central control unit (20) connected by control lines to the positioning units (9, 10, 11, 13, 14, 15) and preferably optical detection means (6, 18).

6. Device as claimed in Claim 5, wherein there are at least 3, preferably 4, detection units (6) spaced in a defined manner to a given wafer receiving position for detection of the exact position of the wafer (7) in the x-direction and the y-direction as the wafer position information, the wafer position information being retrievable via a line from the control unit (20).

7. Device as claimed in one of the preceding claims, wherein the wafer (7) can be accommodated exactly in the center on a receiving unit (8) and the receiving unit (8) is located between the wafer (7) and the wafer positioning units (9, 10, 11).

8. Device as claimed in Claim 7, wherein the receiving unit (8) has a marking (19) which can be assigned exactly to the center of the wafer (7), and a detection unit ( 18) attached to the die receiving unit (21) of the upper die (5o) detects the offset and/or the distance of the upper die (5o) to the wafer (7) as the die position information, the die position information being retrievable via a line from the control unit (20).

9. Method for producing a nanostructured wafer (7) with the following process steps:
a) depositing a wafer (7) on a receiving unit (8) of the device for producing a nanostructured wafer (7),
b) exact alignment of the wafer (7) to a lower die (5u) by means of a separate wafer positioning unit (9, 10, 11) in the x-direction, y-direction and z-direction and to an upper die (5o) by means of a separate wafer positioning unit (13,14,15) in the x-direction, y-direction and z-direction and
c) transferring a defined nanostructure of the nanostructured die (5u, 5o) to the wafer bottom (7u) and the wafer top (7o) of the wafer (7).

10. Method as claimed in Claim 9, wherein the wafer (7) is aligned between two nanostructured dies (5u, 5o) which are aligned oppositely, preferably parallel to one another, preferably parallel to the dies (5u, 5o).

11. Method as claimed in Claim 9 or 10, wherein the alignment of the wafer (7) to the dies (5u, 5o) is controlled by detection means (6, 18) which detect the relative positions of the wafer (7) and the two dies (5u, 5o) by a central control unit (20) which controls positioning units (9, 10, 11, 13, 14, 15).

## Revendications

1. Dispositif de production d'un disque nanostructuré (7) avec une face de disque supérieure (7o) et une face de disque inférieure (7u), dans lequel le dispositif présente un poinçon nanostructuré supérieur (5o) et un poinçon nanostructuré inférieur (5u) pour reporter une nanostructure définie du poinçon inférieur (5u) sur la face de disque inférieure (7u) et pour reporter une nanostructure définie du poinçon supérieur (5o) sur la face de disque supérieure (7o), **caractérisé en ce qu'**il est prévu une unité de positionnement de disque distincte (9, 10, 11) dans la direction x (10), la direction y (11) et la direction z (9) pour le positionnement exact du disque (7) par rapport au poinçon (5u) associé à la face de disque inférieure (7u) et une unité de positionnement de poinçon distincte (13, 14, 15) dans la direction x (14), la direction y (15) et la direction z (13) pour le positionnement exact du poinçon (5o) associé à la face de disque supérieure (7o) par rapport au poinçon (5u) aligné sur le disque (7).

2. Dispositif selon la revendication 1, **caractérisé en ce que** le dispositif présente deux poinçons nanostructurés (5u, 5o) alignés de façon opposée, de préférence parallèle, l'un à l'autre, dans lequel le disque (7) peut être disposé en alignement entre les poinçons (5u, 5o) de préférence en parallèle aux poinçons (5u, 5o).

3. Dispositif selon la revendication 1 ou 2, **caractérisé en ce que** le dispositif présente au moins une unité de réception de poinçon (2, 21) associée à chaque poinçon (5u, 5o), à laquelle est associée l'unité de positionnement de disque (9, 10, 11, 13, 14, 15) correspondante pour un positionnement exact du disque (7) par rapport au(x) poinçon(s) (5u, 5o).

4. Dispositif selon la revendication 2, **caractérisé en ce que** les poinçons (5u, 5o) peuvent être fixés par l'intermédiaire de supports de poinçon (4, 17) à l'unité de réception de poinçon (2, 21), en particulier par l'application d'une dépression au niveau de rainures à vide (3, 16) disposées entre l'unité de réception de poinçon (2, 21) et le support de poinçon (4, 17).

5. Dispositif selon la revendication 1, **caractérisé en ce que** le positionnement/l'alignement du disque (7) et des poinçons (5u, 5o) entre eux est commandé par l'intermédiaire d'une unité de commande centrale (20) reliée par des lignes de commande aux unités de positionnement (9, 10, 11, 13, 14, 15) et à des moyens de détection (6, 18) de préférence optiques.

6. Dispositif selon la revendication 5, **caractérisé en ce qu'**au moins 3, de préférence 4, unités de détection (6) sont prévues, espacées de façon définie radialement par rapport à une position de réception de disque spécifiée, pour détecter la position exacte du disque (7) dans la direction x et la direction y sous forme d'informations de position de disque, les informations de position de disque pouvant être récupérées de l'unité de commande (20) par l'intermédiaire d'une ligne.

7. Dispositif selon l'une quelconque des revendications précédentes, **caractérisé en ce que** le disque (7) peut être reçu de façon exactement centrée sur une unité de réception (8) et l'unité de réception (8) est disposée entre le disque (7) et les unités de positionnement de disque (9, 10, 11).

8. Dispositif selon la revendication 7, **caractérisé en ce que** l'unité de réception (8) présente un marquage (19) pouvant être associé exactement au centre du disque (7), et **en ce qu'**une unité de détection (18) montée sur l'unité de réception de poinçon (21) du poinçon supérieur (5o) détecte le décalage et/ou l'éloignement du poinçon supérieur (5o) par rapport au disque (7) sous forme d'informations de position de poinçon, les informations de position de poinçon pouvant être récupérées de l'unité de commande (20) par l'intermédiaire d'une ligne.

9. Procédé de production d'un disque nanostructuré (7) comprenant les étapes consistant à :
a) déposer un disque (7) sur une unité de réception (8) d'un dispositif de production d'un disque nanostructuré (7),
b) aligner exactement le disque (7) par rapport à un poinçon inférieur (5u) au moyen d'une unité de positionnement de disque distincte (9, 10, 11) dans la direction x, la direction y et la direction z, et par rapport à un poinçon supérieur (5o) au moyen d'une unité de positionnement de disque distincte (13, 14, 15) dans la direction x, la direction y et la direction z, et
c) reporter une nanostructure définie des poinçons nanostructurés (5u, 5o) sur la face de disque inférieure (7u) et la face de disque supérieure (7o) du disque (7).

10. Procédé selon la revendication 9, **caractérisé en ce que** le disque (7) est aligné entre les deux poinçons nanostructurés (5u, 5o) alignés de façon opposée, de préférence parallèle, l'un à l'autre, de préférence en parallèle aux poinçons (5u, 5o).

11. Procédé selon la revendication 9 ou 10 **caractérisé en ce que** l'alignement du disque (7) par rapport aux poinçons (5u, 5o) est commandé à l'aide de moyens de détections (6, 18) détectant les positions relatives du disque (7) et des deux poinçons (5u, 5o) par une unité de commande centrale (20) commandant des unités de positionnement (9, 10, 11, 13, 14, 15).
